# EUROPEAN PATENT SPECIFICATION

(11) **EP 0 838 990 B1**
(45) Date of publication and mention of the grant of the patent: **27.11.2002**
(21) Application number: 97307003.0
(22) Date of filing: 10.09.1997
(51) Int. Cl.: H05K 13/00

(54) **Taped electronic-component assembly**
Anordnung gegurteter elektronischer Bauteile
Assemblage en forme de bande-support pour un composant électronique

(30) Priority: 25.09.1996 JP 25305996
(43) Date of publication of application: 29.04.1998
(73) Proprietor: ALPS ELECTRIC CO., LTD., Ota-ku Tokyo 145 (JP)
(72) Inventor: Hayashida, Tsuguhisa, Furukawa-shi, Miyagi-ken (JP)
(74) Representative: Kensett, John Hinton

(56) References cited:
- EP-A- 0 090 050
- US-A- 4 034 893
- US-A- 4 453 633

## Description

The present invention relates to a taped electronic-component assembly to be used in the fabrication of a diversity of electronic apparatus

Conventional taped electronic component assemblies typically available employ a tape to which electronic components adhere, and an automated mounting machine is used to mount the electronic components onto boards of a diversity of electronic apparatuses.

In such a taped electronic-component assembly, the electronic component at its terminals adheres to and held by a tape constructed of a paper base and an adhesive tape, and a plurality of electronic components are attached to the tape.

The conventional taped electronic component employs an electronic component such as a semi-fixed potentiometer.

There is a trend toward the automated mounting of such electronic components as slide-action type pontentiometers, rotary-type potentiometers, and encoders.

The slide-action type potentiometer is provided with an operation shaft (or a lever), and when the taped electronic components (on a band-like tape) are helically wound around a reel or are folded when they are packed, the operation shaft projected out of each of the electronic components makes the taped electronic-component assembly bulky and the packing density of the electronic components is reduced.

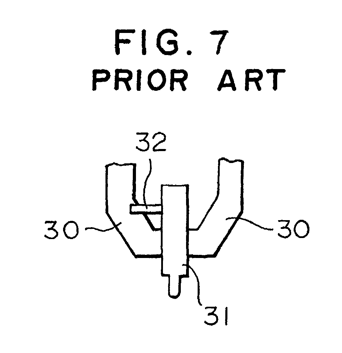

Referring to FIG. 7, when a chuck 30, 30 of an automated mounting machine grips an electronic component 31 from a taped electronic-component assembly during an automatic mounting operation, the chuck 30 may touch the operation shaft 32 suffering chucking difficulty. The operation shaft also presents a difficulty in cutting the terminals of the electronic component from its tape.

It is a first object of the present invention to provide a taped electronic-component assembly in which an electronic component with its operation shaft presents no difficulty in cutting operation of terminals and provides an increased packing density.

It is a second object of the present invention to provide a taped electronic-component assembly in which an electronic component with its operation shaft and snap section presents no difficulty in a chucking operation and a terminal cutting operation, while the electronic component, even with its snap section having a curve portion, is packed at a packing density level as high as that of an electronic component without snap section.

It is a third object of the present invention to provide a taped electronic-component assembly in which a number of electronic components are arranged along the direction of extension of a tape for an efficient packing. The taped electronic-component assembly of the present invention is defined in claim 1.

The electronic component may have a snap section provided on each of both sides of the array of the terminals, wherein the snap section has a plate in perpendicular to the direction of extension of the tape; the plate has a curve portion curved in the direction of extension of the tape; and the snap section is positioned above the tape in a manner such that the snap section is unsupported by the tape.

The operation shaft is attached to the operation shaft mounting section after the electronic component is cut from the tape and mounted on a board.

The electronic component may be a sliding-action type electronic component, wherein the substrate of the sliding-action type electronic component is generally flush with the plane of the tape, and may be arranged in substantially perpendicular to the direction of extension of the tape.

Embodiments of the present invention will now be described, by way of example only, with reference to the accompanying drawings, in which:
FIGS. 1A and 1B are respectively a front view and a right-side view of a first embodiment of the present invention;
FIG. 2 is a side view, with portions broken away, of the first embodiment of the electronic component of the present invention;
FIGS. 3A, 3B and 3C are explanatory diagrams showing the mounting process of the first embodiment of the present invention;
FIG. 4 is an explanatory diagram showing the terminal cutting process in FIG. 3A;
FIG. 5 is a side view of the electronic component shown in FIG. 3C;
FIG. 6 is a side view, with portions broken away, of a second embodiment of the electronic component of the present invention;
FIG. 7 is an explanatory diagram showing a conventional electronic component.

Referring now to the drawings, embodiments of the present invention are now discussed.

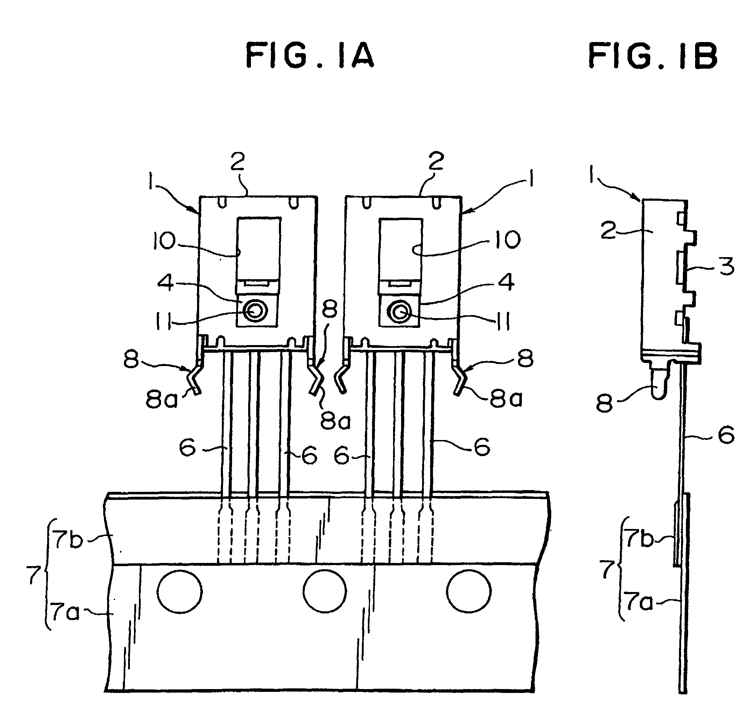

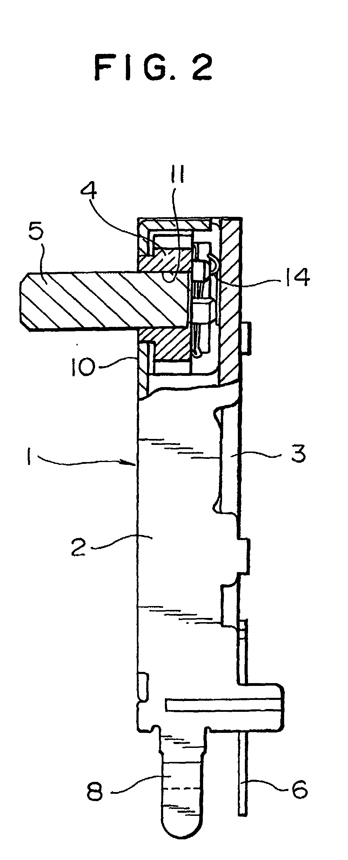

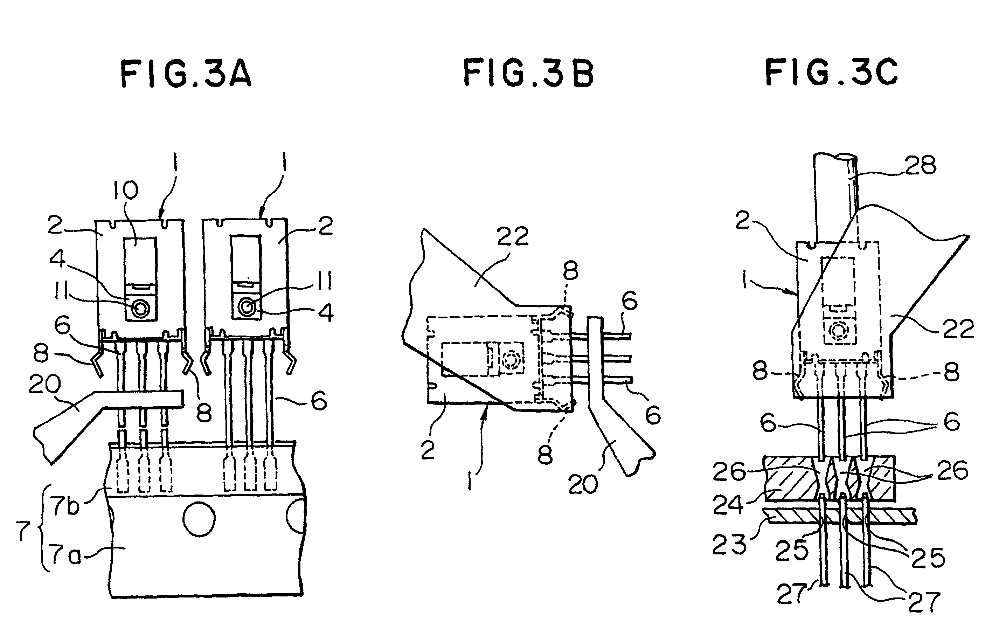

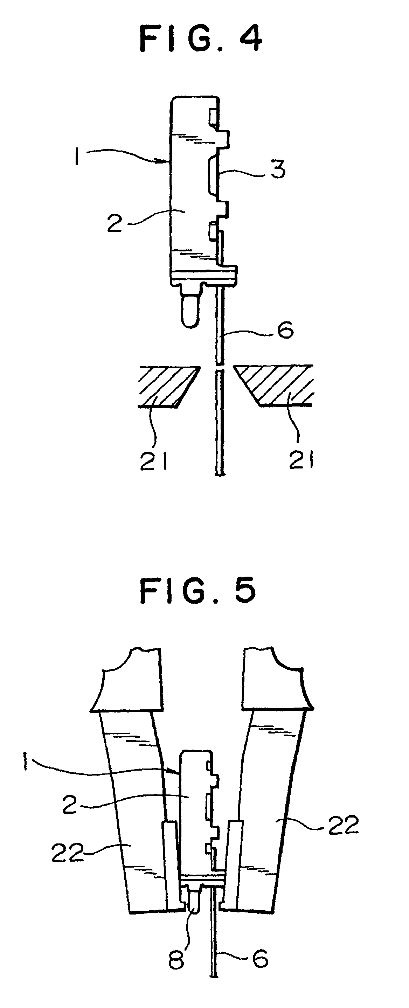

FIGS. 1A and 1B are respectively front and right-side views of a first embodiment of the present invention, FIG. 2 is a side view, with portions broken away, of the first embodiment of the electronic component of the present invention, FIGS. 3A, 3B and 3C are explanatory diagrams showing the mounting process of the first embodiment of the present invention, FIG. 4 is an explanatory diagram showing a cutting operation in FIG. 3A, and FIG. 5 is a side view of the electronic component shown in FIG. 3C.

The first embodiment of the present invention is first discussed. In the first embodiment, the electronic component 1 is a slide-action type potentiometer.

The electronic component 1 comprises a box-like case 2, a substrate 3 that is assembled onto the case 2 in a manner such that the opening of the case 2 is closed, a slider 4 slidably supported within the space defined by the case 2 and the substrate 3, an operation shaft 5 detachably engaged with the slider 4 and projected out of the case 2, and terminals 6, 6 connected to resistor and conductor patterns (not shown) formed in the substrate 3 and projected out of the case 2. A sliding contact 14 secured to the slider 4 slidably moves on the substrate 3, integrally with the slider 4.

A band-like tape 7 is constructed of a paper base 7a and an adhesive tape 7b, and the lower ends of the terminals 6, 6, 6 of the electronic component 1 adhere and are held between the paper base 7a and the adhesive tape 7b. A plurality of electronic components 1, 1... are consecutively arrayed along one edge portion of the band-like tape 7.

The electronic component 1 has, on both sides, snap sections 8, 8 extended from side plates of the case 2 on both sides of the array of the terminals 6, 6, 6 of the electronic component 1 (in the direction of extension of the tape 7). Each of the snap sections 8 has a plate perpendicular to the direction of extension of the tape 7, has an inwardly-concave curve portion 8a, 8a and is positioned above the tape 7 without being supported by the tape 7. The center one of the terminals 6, 6, 6 of the electronic component 1 may be set to be shorter than the remaining terminals so that the center terminal remains unsupported by the tape 7.

The slider 4 of the electronic component 1 has a socket 11 in the opening 10 of the case 2, and after the electronic component 1 is mounted on a board 23 to be described later, the operation shaft 5 is press-fitted into the socket 11 as shown in FIG. 2.

The automatic mounting operation of the first embodiment is now discussed referring to FIGS. 3A-3C, 4 and 5.

A first chuck 20 of an automatic mounting machine clamps (chucks) the terminals 6, 6, 6 of the electronic component 1 of the taped electronic-component assembly, and a pair of cutters 21, 21 cut the terminals 6, 6, 6 at their lower ends to disconnect them from the tape 7 (see FIG. 3A). As described above, the electronic component 1 prior to mounting has no operation shaft 5 attached.

The first chuck 20 is moved to rotate the electronic component 1 clamped by 90° in the direction of an arrow, and a second chuck 22 of the automatic mounting machine clamps (chucks) the electronic component 1 by the case 2 as shown in FIG. 3B. The first chuck 20 is then released. In this way, the electronic component 1 is relayed from the first chuck 20 to the second chuck 22.

The second chuck 22 is moved from the state shown in FIG. 3B in the direction of an arrow by 90° to set the electronic component 1 at its mounting position on the board 23 as shown in FIG. 3C and FIG. 5. The electronic component 1 is now held by the second chuck 22, 22 with its terminals 6, 6 down.

In the state shown in FIG. 3C, a guide plate 24 is placed above the board 23, and the guide plate 24 is provided with guide holes 26 corresponding to terminal mounting holes 25 in the board 23. Designated 27 are vertically movable guide pins. Since these guide holes 26 are tapered from both ends so that their center diameter is smaller than their end diameters, they permit the terminals 6 and the guide pins 27 to be easily inserted therethrough while assuring mounting position accuracy of the terminals 6.

When the guide plate 24 is set above the board 23, the guide pins 27 are inserted from below through the terminal mounting holes 25 in the board 23 and the guide holes 26 in the guide plate 24, and the guide plate 24 is thus aligned to its predetermined position.

Referring to FIG. 3C, a pusher 28 exerts a load to the electronic component 1 clamped by the second chuck 22 from above to lower the electronic component 1 downward, the terminals 6, 6 are guided through the guide holes 26 in the guide plate 24 and inserted through the terminal mounting holes 25 in the board 23 from which the guide pins 27 are retracted, and the electronic component 1 is thus mounted onto the board 23.

After the mounting, the operation shaft 5 is press-fitted into the socket (an operation shaft mounting section) 11 in the slider 4 of the electronic component 1 as shown in FIG. 2.

A second of the present invention is now discussed.

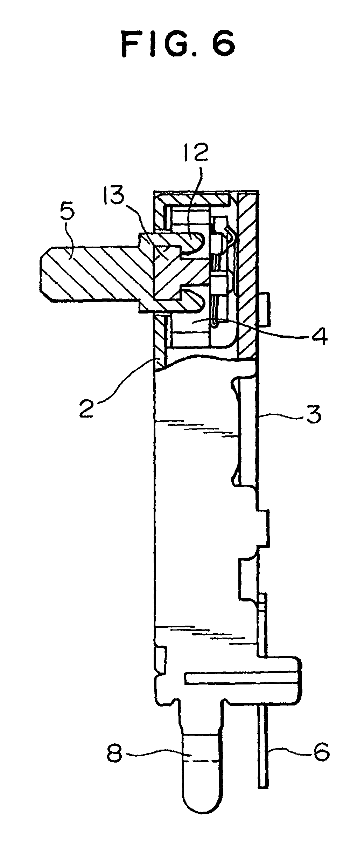

FIG. 6 is a side view, with its portions broken away, of the second embodiment of the electronic component 1 of the present invention. The components identical to those in the first embodiment are designated with the same reference numerals and their explanation will not be repeated.

In the second embodiment, the operation shaft 5 has integrally a pair of snap catches 12, 12 on its one end, while the slider 4 of the electronic component 1 is provided with lock portions 13, 13.

The snap catches 12, 12 of the operation shaft 5 are engaged with the lock portions 13, 13 of the slider 4 after the electronic component 1 is mounted onto the board 23 described later.

The second embodiment is mounted in the same manner as the first embodiment, though its description is not repeated here.

The present invention is not limited to the above embodiments, and may be applied to a diversity of electronic component types including a rotary type potentiometer, an encoder, and in particular to electronic component types that are operated by an operation shaft and a lever.

Each of the above embodiments comprises the electronic components 1 having the operation shaft mounting section (11, 13) with which the operation shaft 5 is detachably engaged, and the band-like tape 7 that consecutively holds the electronic components 1 by making the terminals of the electronic components 1 adhere to the tape 7. The operation shaft 5 is attached to the operation shaft mounting section (11, 13) after each electronic component 1 is assembled. Since the operation shaft 5 does not interfere with the chucking operation of the electronic component 1 and chucking operation of the terminals 6, the mounting of the electronic component 1 is easy. When the tape is reel-wound, tape radial thickness per turn is made thin and the packing density is increased.

In each of the above embodiments, the electronic component 1 is provided with the snap sections 8, 8 on both sides of the array of the terminals. Each of the snap sections 8, 8 has a plate perpendicular to the direction of extension of the tape 7. The plate is curved in the direction of extension, and is placed above the tape 7 in a manner that allows the plate to be unsupported by the tape 7. The operation shaft 5 and snap sections 8, 8 therefore do not interfere with the chucking operation of the electronic component 1 and the cutting operation of the terminals 6. The electronic component 1 has no operation shaft 5 attached prior to the mounting, and the curve of the curve portion 8a of each of the snap sections 8, 8 is aligned in the direction of extension of the tape 7. The electronic components 1 are thus packed at a packing density as high as the electronic component without snap sections 8, 8.

In each of the above embodiments, the electronic components 1 are consecutively held along the band-like tape 7 with the terminals 6 adhering thereto. Each electronic component 1 has the snap sections 8, 8 on both sides of the array of the terminals 6. Each of the snap sections 8, 8 has a plate in perpendicular to the direction of extension of the tape 7. The plate is curved in the direction of extension to form the curve portion 8a and is positioned above the tape 7 in a manner that allows the plate to be unsupported by the tape 7. The snap sections 8, 8 do not interfere with the chucking operation of the electronic component 1 and the cutting operation of the terminals 6. The electronic component 1 can stand on its own snap sections 8, 8 on both sides. The curve of the curve portion 8a of each of the snap sections 8, 8 is aligned in the direction of extension of the tape 7, and the electronic components 1 are thus packed at a packing density as high as the electronic component without snap sections 8, 8.

In each of the above embodiments, the electronic component 1 is of the sliding-action type and the substrate 3 of the sliding-action type electronic component is generally flush with the plane of the tape 7, and is arranged in substantially perpendicular to the direction of extension of the tape 7, and a number of electronic components 1 are arranged in the direction of extension of the tape 7 permitting an efficient packing.

According to the invention as described above, the electronic component without operation shaft does not interfere with the chucking operation and terminal cutting operation and facilitates mounting, and when the tape is reel-wound, tape radial thickness per turn is made thin and the packing density is increased.

According to the invention as described above, the operation shaft and the snap sections do not interfere with the chucking and terminal cutting operations. The electronic component has no operation shaft prior to the mounting and the curve of the curve portion is aligned with the direction of extension of the tape, and the electronic components are thus packed at a packing density as high as the electronic components without snap sections.

According to the invention as described above, a number of electronic components are arranged in the direction of extension of the tape, permitting an efficient packing.

## Claims

1. A taped electronic-component assembly comprising:
at least one electronic component (1) comprising a case (2) provided with an opening (10), and a movable section (4) that is slidable or rotatable within the opening; and
a band-like tape (7) that holds the or each electronic component by adhering projected terminals (6) of each electronic component to the tape,
wherein the moveable section is stored in the opening of the case such that the moveable section does not project from the case, an operation shaft mounting section (11, 13) is provided for the moveable section, an operation shaft (5), for operating the moveable section and projecting from the case is attachable to the operation shaft mounting section after the electronic component is cut from the tape and is mounted on a board (23), the operation shaft mounting section being positioned to face the opening, and the opening being positioned to face the same plane as the plane of the band-like tape.

2. A taped electronic-component assembly according to Claim 1, wherein the electronic component has an array of terminals and has a snap section (8) provided on each of both sides of the array of the terminals, and
wherein the snap section has a plate perpendicular to the direction of extension of the tape; the plate has an arcuate portion (8a) curved in the direction of extension of the tape; and the snap section is positioned above the tape in a manner such that the snap section is unsupported by the tape.

3. A taped electronic-component assembly according to claim 1 or 2, wherein the electronic component is a sliding-action type electronic component, and wherein a substrate (3) of the sliding-action type electronic component is generally flush with the plane of the tape and is arranged in substantially perpendicular to the direction of extension of the tape.

## Patentansprüche

1. Anordnung gegurteter elektronischer Bauteile aufweisend:
mindestens ein elektronisches Bauteil (1), das ein mit einer Öffnung (10) versehenes Gehäuse (2) und einen beweglichen Abschnitt (4) aufweist, der sich in der Öffnung gleitend verschieblich oder drehbar bewegen lässt; und
einen bandartigen Gurt (7), welcher das oder jedes der elektronischen Bauteile haltert. indem er hervorstehende Anschlüsse (6) eines jeden elektronischen Bauteils mit dem Band haftend verbindet,
wobei der bewegliche Abschnitt in der Öffnung des Gehäuses derart untergebracht ist, das der bewegliche Abschnitt nicht aus dem Gehäuse hervorsteht, ein Betätigungsschaft-Anbringungsabschnitt (11, 13) für den beweglichen Abschnitt vorgesehen ist, ein Betätigungsschaft (5), der zur Betätigung des beweglichen Abschnitts dient und aus dem Gehäuse hervorragt, sich an dem Betätigungsschaft-Anbringungsabschnitt anbringen lässt, nachdem das elektronische Bauteil vom Gurt abgeschnitten und an einer Platine (23) befestigt wurde, und der Betätigungsschaft-Anbringungsabschnitt so positioniert ist, das er zur Öffnung weist, und die Öffnung so positioniert ist, dass sie zu derselben Ebene wie die Ebene des bandartigen Gurtes weist.

2. Anordnung gegurteter elektronischer Bauteile nach Anspruch 1, bei welcher das elektronische Bauteil eine Gruppierung von Anschlüssen und einen Schnappabschnitt (8) aufweist, der auf jeder der beiden Seiten der Gruppierung von Anschlüssen vorgesehen ist, und
wobei der Schnappabschnitt eine senkrecht zur Verlaufsrichtung des Gurtes angeordnete Platte aufweist; die Platte ein bogenförmiges Teilstück (8a) aufweist, das in Verlaufsrichtung des Bandes gekrümmt ist; und der Schnappabschnitt oberhalb des Bandes derart positioniert ist, das der Schnappabschnitt nicht durch den Gurt getragen wird.

3. Anordnung gegurteter elektronischer Bauteile nach Anspruch 1 oder 2, bei welcher das elektronische Bauteil ein elektronisches Bauteil vom gleitend verschieblichen Betätigungstyp ist, und bei welcher ein Trägermaterial (3) des elektronischen Bauteils vom gleitend verschieblichen Betätigungstyp im Wesentlichen mit der Ebene des Gurtes fluchtet und im Wesentlichen senkrecht zur Verlaufsrichtung des Bandes angeordnet ist.

## Revendications

1. Ensemble de composants électroniques mis en bande comprenant:
au moins un composant électronique (1) comprenant un boîtier (2) avec une ouverture (10) et une section mobile (4) pouvant être glissée ou tournée dans l'ouverture, et
une bande ruban (7) qui tient le ou chaque composant électronique en faisant adhérer à la bande les connexions en projection (6) de chaque composant électronique,
dans lequel la section mobile est rangée dans l'ouverture du boîtier de sorte que la section mobile ne sorte pas du boîtier, une section de montage de l'axe opératoire (11, 13) étant prévue pour la section mobile, un axe opératoire (5) pour actionner la section mobile et ressortant du boîtier pouvant être fixé à la section de montage de l'axe opératoire une fois que le composant électronique est coupé de la bande et monté sur une carte (23), la section de montage de l'axe opératoire étant positionnée pour faire face à l'ouverture et l'ouverture étant positionnée pour faire face au même plan que le plan de la bande ruban.

2. Ensemble de composants électroniques mis en bande selon la revendication 1, dans lequel le composant électronique comprend un réseau de connexions et une section à enclenchement (8) prévue sur chacun des deux côtés du réseau de connexions, et
la section à enclenchement comprend une plaque perpendiculaire au sens d'extension de la bande; la plaque comprend une section en arc (8a) recourbée dans le sens d'extension de la bande; et la section à enclenchement est positionnée au-dessus de la bande de sorte que la section à enclenchement ne soit pas soutenue par la bande.

3. Ensemble de composants électroniques mis en bande selon la revendication 1 ou 2, dans lequel le composant électronique et un composant électronique de type à glissement, et dans lesquel un substrat (3) du composant électronique du type à glissement est en général au même niveau que le plan de la bande et sensiblement perpendiculaire au sens d'extension de la bande.
